# EUROPÄISCHE PATENTSCHRIFT

(11) **EP 2 699 916 B1**
(45) Veröffentlichungstag und Bekanntmachung des Hinweises auf die Patenterteilung: **04.03.2015**
(21) Anmeldenummer: 12728183.0
(22) Anmeldetag: 14.06.2012
(51) Int. Cl.: H02K 11/00, G01R 31/34

(54) **Überwachungsvorrichtung für eine doppelgespeiste Asynchronmaschine**
Monitoring apparatus for a doubly-fed asynchronous machine
Dispositif de surveillance pour une machine asynchrone à double alimentation

(30) Priorität: 27.07.2011 DE 102011108591
(43) Veröffentlichungstag der Anmeldung: 26.02.2014
(73) Patentinhaber: Voith Patent GmbH, 89522 Heidenheim (DE)
(72) Erfinder: HILDINGER, Thomas, 89522 Heidenheim (DE); KÖDDING, Ludger, 89518 Heidenheim (DE)
(74) Vertreter: Dr. Weitzel & Partner
(86) Internationale Anmeldenummer: PCT/EP2012/002502
(87) Internationale Veröffentlichungsnummer: WO 2013/013739

(56) Entgegenhaltungen:
- EP-A2- 0 391 181
- WO-A1-00/69062
- WO-A1-2004/025316
- WO-A1-2006/134068
- WO-A1-2009/071656
- WO-A1-2010/070465
- US-A- 3 831 160

## Beschreibung

Die Erfindung betrifft eine doppelgespeiste elektrodynamische Asynchronmaschine mit einer Überwachungsvorrichtung nach dem Oberbegriff des Anspruchs 1, sowie ein entsprechendes Verfahren zum Überwachen einer doppelgespeisten elektrodynamischen Maschine nach Anspruch 8. Zudem betrifft die Erfindung eine bevorzugte Verwendung der doppelgespeisten elektrodynamischen Asynchronmaschine nach Anspruch 11.

Wenn bei elektrodynamischen Maschinen eine Lagerisolierung bricht, wird durch Asymmetrien der Maschine zwischen deren Wellenenden ein Wellenstrom erzeugt, der die Lager der Maschine beschädigen kann. Die vorstehend genannten Lager können dabei alle Arten von Lagerungen, insbesondere aber Führungslager, Traglager und/oder Spurlager umfassen. Das Ausmaß der Beschädigung hängt dabei von der Höhe und Dauer des Wellenstroms ab. Bei Synchronmaschinen sind zur rechtzeitigen Erkennung derartiger Wellenströme Überwachungsvorrichtungen bekannt, die Wellenströme von einem Ampere oder weniger erkennen, wie z.B. die ABB Raric Shaft Current Protection. Die Überwachung basiert darauf, dass der Wellenstrom gemessen und Grenzwerte definiert werden, deren Überschreiten signalisiert wird.

Bei doppelgespeisten Asynchronmaschinen wird es dagegen immer einen Wellenstrom geben, da sich die drei Phasenspannungen des Umrichters nicht zu Null addieren. Zudem ergeben sich auf Grund der getakteten Spannungsaufschaltung sehr hohe Spannungsänderungen bzw. eine spannungsharmonisch sehr hohe Frequenz. Abhängig vom Betriebszustand treten damit unterschiedliche Wellenströme auf, womit die klassische Wellenstromüberwachung zum Beispiel der ABB nicht verwendet werden kann. Dennoch muss vermieden werden, dass Wellenströme über die Isolationsschicht oder den Ölfilm von der Welle zu einem Lager fließen.

Aus der DE 196 34 366 A1 ist eine Einrichtung bekannt, mit deren Hilfe elektrische Parameter wie der Isolationswiderstand eines Asynchronmotors bestimmt werden können. Der Spannungsabgriff erfolgt dabei über Tastköpfe an Motoranschlussklemmen.

In der DE 15 13 706 A wird an rotierenden Teilen einer Synchronmaschine eine Spannung über eine Isolation hinweg gegen Masse gemessen. Der Spannungsabgriff erfolgt über Bürsten und Schleifringe. Die Isolationsschicht isoliert dabei einen rotierenden Stromkreis von der Schwelle der Synchronmaschine, wobei die Schwelle als Masse dient.

Zum weiteren Stand der Technik wird auf die Schriften:
US 3,831,160;
EP 0 391 181 A2;
WO 2010/070465 A1;
WO 2006/134068 A1; und
WO 2009/071656 A1
hingewiesen.

Es ist Aufgabe der vorliegenden Erfindung, eine doppelgespeiste elektrodynamische Asynchronmaschine bereitzustellen, welche die vorstehenden Probleme löst und eine einfache, wirksame und zuverlässige Überwachung des Wellenstroms ermöglicht.

Diese Aufgabe wird von einer Asynchronmaschine gemäß kennzeichnendem Teil des Anspruchs 1 gelöst. Die erfindungsgemäße Lösung geht dabei zunächst davon aus, dass der Weg des Stroms über eine Isolationsschicht überwacht und gemessen werden muss. Da bei doppelgespeisten Asynchronmaschinen allerdings immer Wellenströme auftreten, ist daraus keine Aussage über den Zustand der Maschine abzuleiten. Ein wesentlicher Punkt der erfindungsgemäßen Asynchronmaschine mit der Überwachungsvorrichtung liegt nun darin, nicht den Strom, sondern die Spannung über eine Isolationsschicht hinweg zu bestimmen, und aus dieser eine Aussage über deren Zustand abzuleiten. Die Spannung wird dabei gegen ein Nullpotenzial gemessen, dass üblicherweise am Stator der doppelgespeisten elektrodynamischen Asynchronmaschine anliegt. Eine entsprechende Mess- und Signalisierungseinheit ist dabei mit Kontaktelementen zum Messen der Spannung verbunden, sowie zum Abgeben eines Warnsignals ausgebildet, das den Zustand der Maschine wiedergibt und eine Entscheidung über ein weiteres Vorgehen ermöglicht.

Dabei ist es vorgesehen, dass das wenigstens eine Lager eine ringförmige erste Isolationsschicht umfasst. Die Bestimmung eines Spannungsabfalls direkt über das Lager hinweg stellt dabei den unmittelbarsten Weg dar, einen Leckagestrom und damit eine Beschädigung der Maschine festzustellen. Die erforderlichen Kontaktpunkte können dabei an oder in dem Lager vorgesehen sein, womit eine modulartige Lager- und Messvorrichtung entsteht, die weitere Modifikationen der Maschine überflüssig macht.

Dabei ist zwischen dem wenigstens einen Lager und der Welle eine zweite ringförmige Isolationsschicht angeordnet. Dies ist notwendig, da das Lager allein keinen ausreichenden Widerstand gegen einen Leckagestrom bietet, und damit keinen Spannungsabfall messbar macht. Ist dies dagegen nicht der Fall, kann durch Anbringung der zusätzlichen Isolierung die Ausfallsicherheit der Maschine erhöht werden. In jedem Fall bietet sich aber eine Möglichkeit, einen Spannungsabfall zu messen und eine sichere Überwachung der Maschine zu gewährleisten. Idealerweise ist die zweite Isolationsschicht als Glasfaserschicht, Polyester- oder Kaptonfilm ausgebildet, was eine gleichsam stabile Verbindung von Welle und Lager als auch eine zuverlässige Isolation sicherstellt.

Vorteilhafte Weiterbildungen der Überwachungsvorrichtung sind in den Unteransprüchen angegeben, welche insbesondere geeignete Messpunkte und deren Ausgestaltung betreffen.

Die vorstehende erste Isolationsschicht ist dabei in vorteilhafter Weise als Ölfilm ausgebildet, wie er in vielen Lagern zu deren Schmierung erforderlich ist. Damit erübrigt sich auch die zusätzliche Anbringung einer geeignete Isolationsschicht an oder in dem Lager. Idealerweise ist das wenigstens eine Lager als Gleitlager ausgeführt, das einen Ölfilm oder einen anderen geeignete Schmierflm ohne weitere Kontaktbrücken wie zum Beispiel Kugel- oder Wälzlager verwendet.

Die Kontaktelemente sind in bevorzugter Weise als feststehende Bürsten ausgebildet, welche in radialer Richtung der Welle gesehen vor der ersten und/oder der zweiten Isolationsschicht angeordnet sind. Eine derartige konstruktive Ausgestaltung der Kontaktelemente ist besonders einfach zu realisieren und erfordert insbesondere keine möglicherweise deutlich anfälligere Elektronik. Dennoch ist auch denkbar, ein mitlaufendes Kontaktelement vorzusehen, welche zum Beispiel mit einer Bluetooth-Schnittstelle ausgestattet sind.

Eine besonders flexible Mess- und Signalisierungseinheit ist zum Speichern eines Spannungsgrenzwertes und zum Abgeben des Warnsignals bei Unterschreiten dieses Spannungsgrenzwertes ausgebildet. Damit können - abhängig von jeder Maschinenauslegung und ihren Sicherheitsanforderungen - unterschiedliche Spannungsgrenzwerte vorgegeben werden, die eine jeweils angepasste Überwachung ermöglichen. Eine solche Mess- und Signalisierungseinheit ist insbesondere für unterschiedliche Maschinentypen und Belastungsszenarien verwendbar.

Bevorzugt ist die erfindungsgemäße Überwachungsvorrichtung mit einer Abschalteinheit ausgestattet, die zum Abschalten der doppelgespeisten elektrodynamischen Asynchronmaschine in Ansprechen auf das Warnsignal ausgebildet ist. Damit ist eine potentielle Beschädigung der Maschine sicher ausgeschlossen.

Die einführend bezeichnete Aufgabe wird auch durch ein Verfahren nach Anspruch 9 gelöst, bei dem ein Spannungsabfall über eine entsprechende Isolationsschicht des Lagers hinweg gemessen wird. Auch dieses Verfahren lässt eine besonders einfache, wirksame und zuverlässige Überwachung einer doppelgespeisten elektrodynamischen Asynchronmaschine zu. Eine besondere Flexibilität wird erreicht, wenn ein Spannungsgrenzwert vorgebbar ist, bei dessen Unterschreiten ein Warnsignal abgegeben wird. Idealerweise wird die doppelgespeiste elektrodynamische Asynchronmaschine in Ansprechen auf das abgegebene Warnsignal abgeschaltet, um eine Beschädigung von deren Lagern sicher auszuschließen.

In bevorzugter Weise wird die Überwachungsvorrichtung in einem Motorgenerator eingesetzt, der hohen Wechselbelastungen unterliegt.

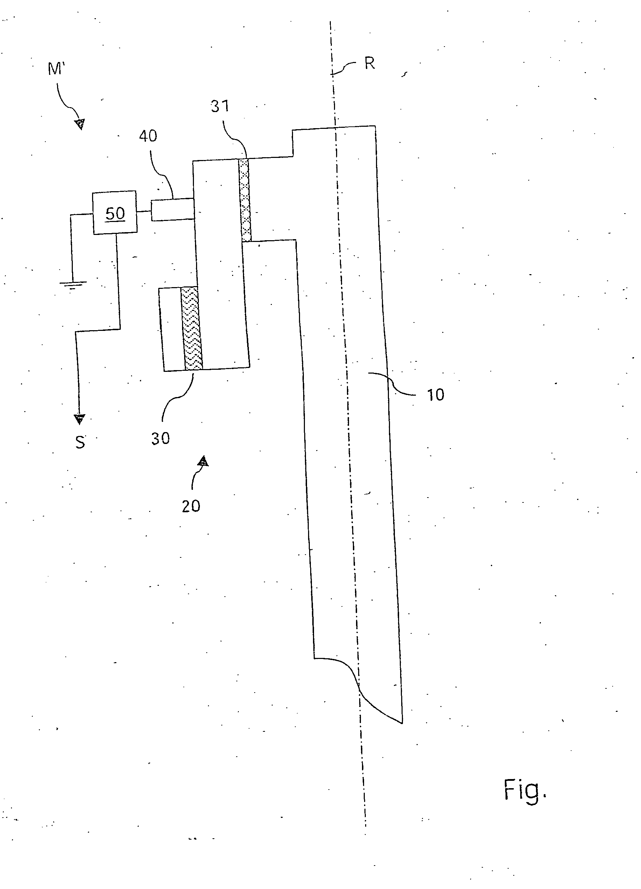

Die vorliegende Erfindung wird im Folgenden anhand eines Ausführungsbeispiels unter Bezugnahme auf die beiliegende Figur näher erläutert. Es zeigt:
- Figur: eine Ausführungsform einer erfindungsgemäßen Überwachungsvorrichtung für eine doppelgespeiste elektrodynamische Asynchronmaschine, welche den Spannungsabfall über nur eine Isolationsschichten erfasst, welche in dem Lager der elektrodynamischen Asynchronmaschine angeordnet ist.

Die Figur zeigt einen Ausschnitt einer doppelgespeisten elektrodynamischen Asynchronmaschine, welche über zwei Isolationsschichten 30, 31 verfügt, die zum einen in einem Lager 20 und zum anderen zwischen diesem Lager 20 und der Welle 10 der doppelgespeisten elektrodynamischen Asynchronmaschine angeordnet sind. Das Lager 20 soll dabei als Gleitlager mit einem Ölfilm ausgebildet sein, der als erste Isolationsschicht 30 wirkt. Die zweite Isolationsschicht 31 läuft dabei mit der Welle 10 um, wenn sich diese um ihre Rotationsachse R dreht.

Die Figur zeigt eine Ausführungsform einer erfindungsgemäßen Überwachungsvorrichtung M' für eine doppelgespeiste elektrodynamische Asynchronmaschine, welche den Spannungsabfall über nur eine der Isolationsschichten 30, 31 erfasst, nämlich die, welche in dem Lager 20 der doppelgespeisten elektrodynamischen Asynchronmaschine angeordnet ist. Ein Kontaktelement 40 ist als Bürste ausgebildet, die gegen den mit der Welle 10 umlaufenden Teil des Lagers 20 anliegt und mit einer Mess- und Signalisierungseinheit 50 verbunden ist. Diese Einheit 50 misst einen Spannungsabfall über die Isolationsschicht 30 hinweg zu einem Nullpotenzial, das üblicherweise am Stator der Asynchronmaschine anliegt. Das Lager 20 soll als Gleitlager mit einem Ölfilm ausgebildet sein, obwohl auch andere Schmierstoffe zur Anwendung gelangen könnten. Die Lage der Bürste 40 ermöglicht eine direkte Messung des Spannungsabfalls über das Lager 20 hinweg und damit eine besonderes sichere Aussage über dessen Zustand. Die Einheit 50 ist so ausgestaltet, dass bei Unterschreiten eines vorgegebenen Spahnungsgrenzwerts ein Warnsignal S abgegeben wird, das einen Leckstrom anzeigt. In Ansprechen auf dieses Signal S kann z.B. ein Abschalten der Maschine erfolgen, um eine Beschädigung des Lagers 20 auszuschließen.

Das Abschalten der doppelgespeisten elektrodynamischen Asynchronmaschine kann natürlich per Hand durch das Bedienpersonal geschehen. In welcher Ausführungsform der Überwachungseinrichtung M' auch immer ist aber bevorzugt eine (nicht dargestellte) Abschalteinheit vorgesehen, welche eine weitgehend automatisierte und damit zuverlässige Durchführung dieses Vorgangs zulässt.

## Patentansprüche

1. Doppelgespeiste elektrodynamische Asynchronmaschine, mit
einer Überwachungsvorrichtung (M')
einem Stator und einem darin drehbar gehaltenen Rotorkörper, dessen Welle (10) an wenigstens einem Lager (20) gelagert ist,
wenigstens einer Isolationsschicht (30, 31) zum elektrischen Isolieren des Rotorkörper gegenüber einem Nullpotenzial,
wenigstens einem Kontaktelement (40) zum Abgreifen einer elektrischen Spannung, die über die wenigstens eine Isolationsschicht (30, 31) hinweg gegenüber dem Nullpotenzial anliegt,
einer Mess- und Signalisierungseinheit (50), die zum Messen der anliegenden Spannung mit den Kontaktelementen (40) verbunden und abhängig von der Höhe dieser Spannung zum Abgeben eines Warnsignals (S) ausgebildet ist, wobei
das wenigstens eine Lager (20) eine ringförmige erste Isolationsschicht (30) umfasst,
**dadurch gekennzeichnet, dass**
zwischen dem wenigstens einen Lager (20) und der Welle (10) eine zweite ringförmige Isolationsschicht (31) angeordnet ist, wobei die Spannung gegenüber dem Nullpotenzial über die erste Isolationsschicht (30) abgegriffen wird.

2. Doppelgespeiste elektrodynamische Asynchronmaschine nach Anspruch 1, bei welcher die erste Isolationsschicht (30) als Ölfilm ausgebildet ist.

3. Doppelgespeiste elektrodynamische Asynchronmaschine nach Anspruch 2, bei welcher das wenigstens eine Lager (20) als Gleitlager ausgeführt ist.

4. Doppelgespeiste elektrodynamische Asynchronmaschine nach einem der vorstehenden Ansprüche, bei welcher die zweite Isolationsschicht (31) als Glasfaserschicht, Polyester- oder Kaptonfilm ausgebildet ist.

5. Doppelgespeiste elektrodynamische Asynchronmaschine nach einem der vorstehenden Ansprüche, bei welcher die Kontaktelemente (40) als feststehende Bürsten ausgebildet sind, welche in radialer Richtung der Welle (10) gesehen vor der ersten und/oder der zweiten Isolationsschicht (30, 31) angeordnet sind.

6. Doppelgespeiste elektrodynamische Asynchronmaschine nach einem der vorstehenden Ansprüche, deren Mess-und Signalisierungseinheit (50) zum Speichern eines Sparinungsgrenzwertes und zum Abgeben des Warnsignals (S) bei Unterschreiten dieses Spannungsgrenzwertes ausgebildet ist.

7. Doppelgespeiste elektrodynamische Asynchronmaschine nach einem der vorstehenden Ansprüche, welche zudem eine Abschalteinheit aufweist, die zum Abschalten der doppelgespeisten elektrodynamischen Asynchronmaschine in Ansprechen auf das Warnsignal (S) ausgebildet ist.

8. Verfahren zum Überwachen einer doppelgespeisten elektrodynamischen Asynchronmaschine mit
einem Stator und einem darin drehbar gehaltenen Rotorkörper, dessen Welle (10) an wenigstens einem Lager (20) gelagert ist, wobei das wenigstens eine Lager eine ringförmige erste isolationsschicht (30) umfasst, und
wenigstens einer Isolationsschicht (30, 31) zum elektrischen Isolieren des Rotorkörpers gegenüber einem Nullpotenzial, wobei zwischen dem wenigstens einen Lager (20) und der Welle (10) eine zweite ringförmige Isolationsschicht (31) angeordnet ist, bei dem
eine elektrische Spannung gemessen wird, die über die erste Isolationsschicht (30) hinweg gegenüber dem Nullpotenzial anliegt, und abhängig von der Höhe dieser Spannung ein Warnsignal (S) abgegeben wird.

9. Verfahren nach Anspruch 8, bei welchem ein Spannungsgrenzwert vorgebbar ist, bei dessen Unterschreiten das Alarmsignal (S) abgegeben wird.

10. Verfahren nach Anspruch 8 oder 9, bei welchem die doppelgespeiste elektrodynamische Asynchronmaschine in Ansprechen auf das abgegebene Warnsignal (S) abgeschaltet wird.

11. Verwendung der doppelgespeisten elektrodynamischen Asynchronmaschine nach einem der Ansprüche 1 bis 7 als Motorgenerator.

## Claims

1. A double-fed electrodynamic asynchronous machine, having a monitoring device (M')
a stator and a rotor body held rotatably therein, whose shaft (10) is mounted on at least one bearing (20), and
at least one insulation layer (30, 31) for electrical insulation of the rotor body with respect to a zero potential,
at least one contact element (40) for tapping an electric voltage, which is applied with respect to the zero potential by means of said at last one insulation layer (30, 31),
a measuring and signalling unit (50), which is connected to the contact elements (40) for measuring the applied voltage and is designed for emitting a warning signal (S) depending on the height of said voltage,
wherein
said at least one bearing (20) comprises an annular first insulation layer (30),
**characterised in that**
a second annular insulation layer (31) is arranged between said at least one bearing (20) and the shaft (10), wherein the voltage is tapped with respect to the zero potential via the first insulation layer (30).

2. Double-fed electrodynamic asynchronous machine according claim 1, in which the first insulation layer (30) is designed as an oil film.

3. Double-fed electrodynamic asynchronous machine according to claim 2, in which said at least one bearing (20) is designed as a slide bearing.

4. Double-fed electrodynamic asynchronous machine according to one of the previous claims, in which the second insulation layer (31) is designed as a fibre glass layer, a polyester film or a Kapton film.

5. Double-fed electrodynamic asynchronous machine according to one of the previous claims, in which the contact elements (40) are designed as fixed brushes, which are arranged seen in radial direction of the shaft (10) before the first and/or the second insulation layer (30, 31).

6. Double-fed electrodynamic asynchronous machine according to one of the previous claims, whose measuring and signalling unit (50) is designed for storing a voltage limit and for emitting the warning signal (S) when falling below said voltage limit.

7. Double-fed electrodynamic asynchronous machine according to one of the previous claims, which moreover presents a disconnection unit which is designed for switching off the double-fed electrodynamic asynchronous machine in reaction to the warning signal (S).

8. A method for monitoring a double-fed electrodynamic asynchronous machine, having
a stator and a rotor body held rotatably therein, whose shaft (10) is mounted on at least one bearing (20), wherein the at least one bearing (20) comprises an annular first insulation layer (30),and
at least one insulation layer (30, 31) for electrical insulation of the rotor body with respect to a zero potential, in which a second annular insulation layer (31) is arranged between said at least one bearing (20) and the shaft (10), in which
an electric voltage is measured, which is applied with respect to the zero potential by means of the insulation layer (30, 31), and
a warning signal (S) is emitted depending on the height of said voltage.

9. The method of claim 8, in which a voltage limit can be preset, so that the alarm signal (S) is emitted when falling below said voltage limit.

10. The method according to claim 8 or 9, in which the double-fed electrodynamic asynchronous machine is switched off in reaction to the warning signal (S) emitted.

11. The use of the double-fed electrodynamic asynchronous machine according to one of the claims 1 to 7, as a motor generator.

## Revendications

1. Moteur asynchrone électrodynamique à double alimentation,
avec un dispositif de surveillance (M'),
un stator et un rotor monté de manière à pouvoir tourner dans ce dernier, dont l'arbre (10) est monté sur au moins un palier (20),
au moins une couche isolante (30, 31) pour l'isolation électrique du corps du rotor par rapport à un potentiel zéro,
au moins un élément de contact (40) servant à capter une tension électrique, qui se trouve séparée du potentiel zéro par au moins une couche isolante (30, 31)
d'une unité de mesure et de signalisation (50), qui est reliée aux éléments de contact (40) pour la mesure de la tension présente et qui, en fonction de la valeur de cette tension, est configurée pour émettre un signal d'avertissement (S),
où
ledit au moins un palier (20) comprend une première couche isolante (30) annulaire,
caractérisé en ce
une seconde couche isolante (31) annulaire est disposée entre au moins un palier (20) et l'arbre (10), où la tension est capturée par rapport au potentiel zéro par l'intermédiaire de la première couche isolante (30).

2. Moteur asynchrone électrodynamique à double alimentation selon la revendication 1, dans lequel la première couche isolante (30) est sous forme de film d'huile.

3. Moteur asynchrone électrodynamique à double alimentation selon la revendication 2, dans lequel ledit au moins un palier (20) est sous forme de palier de glissement.

4. Moteur asynchrone électrodynamique à double alimentation selon l'une des revendications précédentes, dans lequel la seconde couche isolante (31) est sous forme de couche de fibre de verre, film de polyester ou film de kapton.

5. Moteur asynchrone électrodynamique à double alimentation selon l'une des revendications précédentes, dans lequel les éléments de contact (40) sont constitués de brosses fixes, qui sont agencées dans la direction radiale de l'arbre (10) avant la première et/ou la seconde couche isolante (30, 31).

6. Moteur asynchrone électrodynamique à double alimentation selon l'une des revendications précédentes, dont l'unité de mesure et de signalisation (50) est constituée pour mémoriser une valeur limite de tension et pour émettre le signal d'avertissement (S) en cas de dépassement de cette valeur limite de tension.

7. Moteur asynchrone électrodynamique à double alimentation selon l'une des revendications précédentes, qui présente en outre une unité d'interruption, constituée pour interrompre le moteur asynchrone électrodynamique à double alimentation en réaction au signal d'avertissement (S).

8. Procédé de surveillance d'un moteur asynchrone électrodynamique à double alimentation, comprenant
un stator et un rotor monté de manière à pouvoir tourner dans ce dernier, dont l'arbre (10) est monté sur au moins un palier (20), ledit au moins un palier comprend une première couche isolante (30) annulaire et
au moins une couche isolante (30, 31) pour l'isolation électrique du corps du rotor par rapport à un potentiel zéro, une seconde couche isolante (31) annulaire étant disposée entre au moins un palier (20) et l'arbre (10), où l'on mesure une tension électrique, qui se trouve séparée du potentiel zéro par au moins une couche isolante (30, 31) et un signal d'avertissement (S) est produit en fonction de la valeur de cette tension.

9. Procédé selon la revendication 8, avec lequel une valeur limite de tension peut être prédéterminée, le signal d'alarme (S) étant émis lorsque l'on passe au-dessous de cette valeur.

10. Procédé selon la revendication 8 ou 9, avec lequel le moteur asynchrone électrodynamique à double alimentation est interrompu en réaction au signal d'avertissement (S).

11. Utilisation du moteur asynchrone électrodynamique à double alimentation selon l'une des revendications 1 à 7 comme générateur de moteur.
